# EUROPEAN PATENT APPLICATION

(11) **EP 2 813 548 A1**
(43) Date of publication of application: **17.12.2014**
(21) Application number: 13746725.4
(22) Date of filing: 08.02.2013
(51) Int. Cl.: C08L 77/00, H01L 21/56, H01L 23/29, H01L 23/31

(54) **POWDERED SEALING AGENT, AND SEALING METHOD**

(30) Priority: 09.02.2012 JP 2012026239; 10.02.2012 JP 2012027132
(71) Applicant: Daicel-Evonik Ltd., Shinjuku-ku, Tokyo 163-0912 (JP)
(72) Inventor: ARITA Hiroaki, Himeji-shi Hyogo 671-1281 (JP); NAKAIE Yoshiki, Himeji-shi Hyogo 671-1281 (JP); MUTSUDA Mitsuteru, Himeji-shi Hyogo 671-1281 (JP)
(74) Representative: Grünecker, Kinkeldey, Stockmair & Schwanhäusser
(86) International application number: PCT/JP2013/053045
(87) International publication number: WO 2013/118864

(57) **Abstract**

A sealant capable of tightly sealing an electric device at a low temperature and a sealing method of using the sealant are provided.

The sealant for sealing a device comprises a copolyami de-series resin powder having a particle diameter of not more than 1 mm. The copolyamide- series resin powder contains at least a fine particle (e.g., a copolyamide-series resin particle having an average particle diameter of 20 to 400 µm), or may contain the fine particle in combination with a coarse particle (e.g., a copolyamide-series resin particle having an average particle diameter of 450 to 800 µm). The copolyamide-series resin may be a crystalline resin. The copolyamide-series resin may have a melting point or softening point of 75 to 160°C. The copolyamide-series resin maybe, e.g., abinaryorternarycopolymer. Further, the copolyamide-series resin may contain a unit derived from a long-chain component having a C₈₋₁₆alkylene group (at least one component selected from the group consisting of a C₉₋₁₇lactam and an aminoC₉₋₁₇alkanecarboxylic acid) .

## Description

### TECHNICAL FIELD

The present invention relates to a powdery sealant suitable for sealing a device (or an electronic device) such as a printed wiring board mounted with an electronic part, and a sealing method using the powdery sealant.

### BACKGROUND ART

In order to protect a precision part (or an electronic device) against moisture, dust and other unfavorable substances, the precision part (such as a semiconductor element, a printed wiring board, or a solar cell) is sealed (or encapsulated) with a resin. As the sealing method, a known method of sealing a precision part comprises placing the precision part in a mold cavity and injecting a resin into the cavity. This method uses a thermosetting resin having a low viscosity and a high flowability in many cases.

However, the thermosetting resin shortens a storage life due to an additive (such as a crosslinking agent) added to the thermosetting resin, and requires a relatively long time from injection of the resin into a mold cavity to curing of the resin. Thus, the thermosetting resin cannot allow improvement of efficient production. Further, depending on the species of the resin, it is necessary to cure the resin after molding, which lowers production efficacy.

Moreover, it is known that a thermoplastic resin is injection-molded to seal a precision part. The thermoplastic resin, however, is practically injected at a relatively high temperature and high pressure, and thus a substrate or an electronic part mounted on a substrate is liable to damage and loses the reliability. Japanese Patent Application Laid-Open Publication No. 2000-133665 (JP-2000-133665A, Patent Document 1) discloses a method of sealing a printed wiring board mounted with an electronic part, the method comprising placing a printed wiring board equipped with an electronic part in a mold cavity and injecting a heat-melted polyamide resin having a temperature of 160 to 23 0°C into the mold cavity at apressure range of 2.5 to 25 kg/cm². This document discloses in Examples that a polyamide resin (Series Number 817) manufactured by TRL (France) is injected into a mold at a melting temperature of 190°C and a pressure of 20 kg/cm² to seal a printed wiring board. This method, however, also exposes the electronic part to relatively high temperature and high pressure, and the electronic part is sometimes damaged.

Further, it is also known to seal a device using a film sealant. Japanese Patent Application Laid-Open Publication No. 2008-282906 (JP-2008-282906A, Patent Document 2) relates to a process for producing a solar cell module comprising a solar cell sealed between a substrate and a film by a resin; in the process, a first sealing-resin sheet substantially covering the whole surface of the substrate is disposed between the substrate and the solar cell, and a second sealing-resin sheet substantially covering the whole surface of the substrate is disposed between the film and the solar cell for preparing a layered structure. A plurality of the layered structures are stacked while a back plate is disposed outside the film of an uppermost layered structure, air between the substrate and the film is discharged and the resin is heat-melted and then cooled to seal the cell. This document discloses that the sealing-resin is selected from the group consisting of an ethylene-vinyl acetate copolymer, a poly(vinyl butyral), and a polyurethane.

Japanese Patent Application Laid-Open Publication No. 2009-99417 (JP-2009-99417A, Patent Document 3) discloses an organic electronic device sealing panel which comprises a substrate, an organic electronic device formed on the substrate, and a barrier film sealing the organic electronic device, and a hot-melt member is disposed between the organic electronic device and the barrier film. This document also discloses that the hot-melt member contains amoisture scavenger and a wax and that the hot-melt member is in a thin film having a thickness of not more than 100 µm. Moreover, Japanese Patent Application Laid-Open Publication No. 2009-99805 (JP-2009-99805A, Patent Document 4) discloses a hot-melt member for an organic thin-film solar cell, the member containing a moisture scavenger and a wax. These documents also disclose that the hot-melt member may be in the form of a thin-film, a plate, an amorphous or indefinite, and others.

The film sealant, however, has low adaptability to an uneven portion (a depressed or raised portion) of a device, and thus it is difficult to seal the detailed exact or minutiae form of the device tightly. Further, since the above hot-melt member comprises a wax as a main component, it is difficult to seal the device with higher adhesion.

Japanese Patent Application Laid-Open Publication No. 2001-234125 (JP-2001-234125A, Patent Document 5) discloses a powder coating material for thermal spray coating; in order to prevent the coating material from discoloring even when exposed to high-temperature flames in a coating process, the coating material comprises 0.05 to 2.0 parts by weight of a hindered phenolic antioxidant and 0.05 to 2.0 parts by weight of a phosphite-series antioxidant relative to 100 parts by weight of a thermoplastic resin, and has a medium particle diameter of 50 to 300 µm, a bulk specific gravity of not less than 0.30 g/ml and an angle of repose of not more than 35°. In this document, the thermoplastic resin includes a polyethylene resin, a polypropylene resin, a nylon-11 resin, a nylon-12 resin, an ethylene-vinylacetate copolymer resin, an ethylene-acrylic acid copolymer resin, an ethylene-methacrylic acid copolymer resin, a modified polyethylene resin, and a modified polypropylene resin. An example using a nylon (polyamide) resin (trade name "Grilamid" manufactured by EMS-CHEMIEAG) is also described in this document.

Since the above-mentionedpowder coatingmaterial, however, is melted and sprayed at a high temperature, there is a possibility to easily damage the electronic part in the sealing process and the reliability of the device.

### RELATED ART DOCUMENTS

### PATENT DOCUMENTS

Patent Document 1: JP-2000-133665A (Claims and Examples)
Patent Document 2: JP-2008-282906A (Claims)
Patent Document 3: JP-2009-99417A (Claims and [0024])
Patent Document 4: JP-2009-99805A (Claims)
Patent Document 5: JP-2001-234125A (Claims, [0008], and Example 6)

### SUMMARY OF THE INVENTION

### PROBLEMS TO BE SOLVED BY THE INVENTION

It is therefore an object of the present invention to provide a powdery sealant capable of tightly sealing an electronic device at a low temperature, and a sealing method using the sealant.

Another object of the present invention is to provide a powdery sealant which tightly seals a device even having an uneven portion or a narrow gap, and a sealing method using the sealant.

It is still another object of the present invention to provide a powdery sealant which can effectively be accumulated on an electronic device without dropping out (or falling off) in a case where the sealant is spread (or sprinkled or sprayed) on the electronic device, and a sealing method using the sealant.

It is another object of the present invention to provide a powdery sealant which can melt at a low temperature in a short period of time and can protect an electronic device against thermal damage, and a sealing method using the sealant.

It is still another object of the present invention to provide a powdery sealant which can effectively protect an electronic device against moisture, dust or impact, and a sealing method using the sealant.

It is a further object of the present invention to provide a powdery sealant which can tightly seal an electronic device at a low temperature and can effectively prevent degradation of a sealing film due to weather, and a sealing method using the sealant.

It is a still further object of the present invention to provide an electronic device sealed with the powdery sealant.

### MEANS TO SOLVE THE PROBLEMS

The inventors of the present invention made intensive studies to achieve the above objects and finally found that a copolyamide-series resin powder having a specified particle size distribution allows (1) efficient accumulation on a predetermined (or appointed) region by spreading (or sprinkling or spraying) of the powder on a device or a substrate, (2) rapid melting at a low temperature, (3) shortening of sealing and molding cycles, (4) easy following and molding even an uneven surface of a device, (5) uninhibited device or substrate size, (6) sealing or molding a device even in a thin layer, and (7) molding a device or a substrate with high adhesion and seal-ability; and also found that combination of the copolyamide-series resin with a hindered amine-series light stabilizer at a specified ratio further can (8) effectively prevent degradation (e.g., rough surface, defective appearance) of a sealing film due to weather. The present invention was accomplished based on the above findings.

That is, the powdery sealant (or powdery encapsulant) according to the present invention is a sealant for sealing (encapsulating) a device and comprises a copolyamide-series resin. The sealant contains a copolyamide-series resin particle having a particle diameter (or particle size) of not more than 1 mm (for example, 0.5 µm to 1 mm). The copolyamide-series resin particle contains at least (A) a fine particle [for example, a copolyamide-series resin particle having an average particle diameter of about 20 to 400 µm (e.g., about 40 to 350 µm)]. The copolyamide-series resin particle may comprise the fine particle (A) alone or may comprise the fine particle (A) and (B) a coarse particle having a large average particle diameter in combination. The coarse particle (B) may have an average particle diameter of about 1.2 to 20 times as large as the average particle diameter of the fine particle (A). The coarse particle (B) may have an average particle diameter of about 450 to 800 µm. The ratio of the fine particle (A) relative to 100 parts by weight of the coarse particle (B) may be about 1 to 10 parts by weight. The copolyamide-series resin particle (the whole of the copolyamide-series resin particle) may have an angle of repose of about 35 to 55°.

The copolyamide-series resin may have a melting point or softening point of about 75 to 160°C, for example, a melting point of about 90 to 160°C. The copolyamide-series resin may be crystalline. The copolyamide-seriesresin may comprise a multiple copolymer, for example, at least one selected from the group consisting of a binary copolymer to a quaternary copolymer (e.g., a binary copolymer or a ternary copolymer). Further, the copolyamide-series resin may contain a unit (long-chain unit) derived from a long-chain component having a C₈₋₁₆alkylene group (such as a C₁₀₋₁₄alkylene group), for example, at least one component selected from the group consisting of a C₉₋₁₇lactam and an aminoC₉₋₁₇alkanecarboxylic acid. For example, the copolyamide-series resin may contain a unit derived from an amide-forming (or amide-formable) component (or an amide-forming component for forming a polyamide) selected from the group consisting of a polyamide 11, a polyamide 12, a polyamide 610 , a polyamide 612, and a polyamide 1010; the copolyamide-series resin may comprise at least one member selected from the group consisting of a copolyamide 6/11, a copolyamide 6/12, a copolyamide 66/11, a copolyamide 66/12, a copolyamide 610/11, a copolyamide 612/11, a copolyamide 610/12, a copolyamide 612/12, a copolyamide1010/12,acopolyamide6/11/610,acopolyamide 6/11/612, a copolyamide 6/12/610, and a copolyamide 6/12/612. Moreover, the copolyamide-series resin may be a polyamide elastomer (a polyamide block copolymer) containing a unit (polyamide unit or block) derived from an amide-forming component (or an amide-forming component for forming a polyamide) selected from the group consisting of a polyamide 11, a polyamide 12, a polyamide 610, a polyamide 612 and a polyamide 1010 as a hard segment, if necessary. Further, the copolyamide-series resin may contain a unit derived from at least one component selected from the group consisting of laurolactam, aminoundecanoic acid, and aminododecanoic acid.

The sealant (a sealant for molding and sealing a device) of the present invention may be a powdery sealant (or particulate sealant) further containing a hindered amine-serieslight stabilizer. Specifically, the powdery sealant may contain a copolyamide-series resin (or copolyamide-series resin particle) and a hindered amine-series light stabilizer. The ratio of the hindered amine-series light stabilizer relative to 100 parts by weight of the copolyamide-series resin may be about 0.1 to 2 parts by weight.

The sealant of the present invention may contain an ultraviolet ray absorbing agent (for example, at least one member selected from the group consisting of a benzylidenemalonate-series ultraviolet ray absorbing agent, an oxanili de-series ultraviolet ray absorbing agent, and a benzotriazole-series ultraviolet ray absorbing agent) and/or a heat stabilizer (for example, a hindered phenolic heat stabilizer) in addition to the hindered amine-series light stabilizer.

A process according to the present invention produces a device covered or molded with a copolyamide-series resin by applying (or spreading or sprinkling) the powdery sealant on at least a region (or a portion) of the device, heat-melting the powdery sealant, and cooling the powdery sealant. Thus, the present invention also includes a device (a covered or molded device) of which at least a region (or a portion) is covered or molded with a copolyamide-series resin layer formed by heat-melting the powdery sealant.

Throughout this description, the term "copolyamide-series resin" means not only a copolymer (a copolyamide) of a plurality of amide-forming components, each forming a homopolyamide, but also a mixture of a plurality of copolymers (copolyamides) with different in kind, each containing units of a plurality of the amide-forming components.

### EFFECTS OF THE INVENTION

According to the present invention, a copolyamide-series resin powder having a specified particle size distribution can efficiently be accumulated on an electronic device without dropping out even in a case where the resin powder is spread (or sprinkled) on the electronic device, melt at a low temperature in a short period of time, tightly (or closely) seal an electronic device, and does not damage the reliability of the device. Moreover, the sealant having a particulate form tightly seals a device even having an uneven portion or a narrow gap. Thus, the sealant can effectively protect an electronic device againstmoisture,dust,impact,or others. Further, use of the copolyamide-series resin powder and a hindered amine-series light stabilizer at a specified ratio can effectively prevent degradation (e.g., rough surface due to crack formation, defective appearance due to yellowing) of a sealing film due to weather, tightly seal an electronic device at a low temperature, and does not damage the reliability of the device.

### BRIEF DESCRIPTION OF DRAWINGS

[Fig. 1] Fig. 1 is a graph showing a relationship between a particle diameter and a frequency (%) of each powdery resin particle of Examples.
[Fig. 2] Fig. 2 is a graph showing a relationship between a particle diameter and a cumulative frequency (integration) of each powdery resin particle of Examples.

### DESCRIPTION OF EMBODIMENTS

The powdery sealant (or particulate sealant) of the present invention comprises a copolyamide- series resin. The powdery sealant contains a copolyamide-series resin particle having a particle diameter of not more than 1 mm (for example, 0.5 µm to 1 mm). That is, the powdery sealant may comprise a copolyamide-series resin particle that is classified by a sieve having an opening size of not more than 1 mm (for example, 50 µm to 1 mm) or may be substantially free from a copolyamide-series resin particle having a particle diameter larger than 1 mm.

The copolyamide-series resin particle contains at least a fine particle (fine powder or fine particle group) having a small average particle diameter (or particle size). According to the presentinvention,the copolyamide-series resin particle containing the above-mentioned fine particle has a moderate powder flowability, can be prevented from dropping out of a device or a substrate even after being spread on the device or the substrate, has an increased heat conduction, can be melted rapidly at a low temperature , and can protect a device or a substrate against thermal damage.

It is sufficient that the copolyamide-series resin fine particle has an average particle diameter (the value of the particle diameter at 50% in the cumulative distribution: D₅₀) of 20 to 400 µm. For example, the copolyamide-series resin fine particle may have an average particle diameter of about 25 to 380 µm, preferably about 30 to 370 µm, more preferably about 35 to 360 µm (e.g., about 35 to 300 µm), and particularly about 40 to 350 µm (e.g., about 40 to 200 µm).

The copolyamide-series resin fine particle may have a particle diameter range (particle size) of about 0.01 µm to 1 mm and usually has about 0.1 to 500 µm (e.g., about 0.5 to 300 µm) in practical cases.

The copolyamide-series resin particle may contain the fine particle alone or may contain the fine particle and a coarse particle having a large average particle diameter (or particle size). Spreading of the copolyamide-series resin particle containing the coarse particle alone on a device or a substrate easily causes dropping out of the device or the substrate and increases the quantity of heat needed to melt the resin particle. Combinationuse of the coarse particle and the fine particle reduces the void ratio of the powder (particle group) and increases the number of contact points for each particle; thus the copolyamide-series resin particle can be accumulated on a predetermined site suitably and efficiently, have improved heat conduction between particles, shorten a melting time, and provide a sealing film having little surface roughness.

It is sufficient that the average particle diameter (D₅₀) of the copolyamide-series resin coarse particle is larger than that of the copolyamide-series resin fine particle. The average particle diameter (D₅₀) of the copolyamide-series resin coarse particle may be, for example, about 1.2 to 20 times, preferably about 1.5 to 18 times, and more preferably about 2 to 15 times (e.g., about 2 to 10 times) as large as that of the copolyamide-series resin fine particle. Moreover, the copolyamide-series resin coarse particle may have an average particle diameter (D₅₀) of, for example, about 450 to 800 µm (e.g., about 500 to 700 µm).

The copolyamide-series resin coarse particle may have a particle diameter range (particle size) of about 350 µm to 1 mm and is usually about 400 to 900 µm (for example, about 500 to 800 µm) in practical cases.

The ratio (weight ratio) of the fine particle relative to 100 parts by weight of the coarse particle may be selected from the range of, e.g., about 0.1 to 10000 parts by weight, and may for example be about 0.1 to 100 parts by weight, preferably about 0.5 to 50 parts by weight, and more preferably about 1 to 20 parts by weight (e.g., about 1 to 10 parts by weight).

In the copolyamide-series resin particle (the whole copolyamide-series resin particle), the particle size distribution that shows the relationship between the particle diameter and the frequency may have one or more peaks or may have a shoulder. The fine particle (for example, a fine particle having a particle diameter of 0.01 to 300 µm, preferably a fine particle having a particle diameter of 0.1 to 200 µm) may occupy 0.01 to 100% of the whole copolyamide-series resin particle, or may occupy the majority (for example, 70 to 100%, preferably 80 to 99%) thereof or the minority (for example, 0.1 to 30%, preferably 1 to 20%) thereof. The proportion (numerical proportion) of the fine particle in the whole particle may be calculated, for example, based on the particle size distribution measurable according to the after-mentioned method.

The average particle diameter (D₅₀) of the whole copolyamide-series resin particle may be selected from the range of not more than 1 mm (for example, about 1 to 800 µm, preferably about 10 to 750 µm) and is, for example, about 30 to 750 µm, preferably about 35 to 700 µm, and more preferably about 40 to 650 µm. Moreover, the whole copolyamide-series resin particle has a particle diameter at 30% in the cumulative distribution (D₃₀) of, for example, about 25 to 600 µm and preferably about 30 to 550 µm. Further, the whole copolyamide-series resin particle has a particle diameter at 70% in the cumulative distribution (D₇₀) of, for example, about 50 to 850 µm and preferably about 55 to 800 µm. In the whole copolyamide-series resinparticle, the ratio (D_{70/}D₃₀) of the particle diameter at 70% in the cumulative distribution (D₇₀) relative to the particle diameter at 30% in the cumulative distribution (D₃₀) is, for example, about 1.05 to 2.5, preferably about 1.1 to 2.2, and more preferably about 1.2 to 2.

The particle diameter range (particle size), the average particle diameter and the particle size distribution of the copolyamide-series resin particle can be measured by a measuring apparatus using a laser diffraction method (light-scattering method), for example, a measuring apparatus based on Mie scattering theory [e.g., HORIBA LA920 (manufactured by Horiba, Ltd.)].

The angle of repose of the whole copolyamide-series resin particle (or powdery sealant) is not particularly limited to a specific one as far as the resin particle has a moderate powder flowability and can suitably and efficiently be accumulated on a predetermined site of a device or a substrate. For example, the angle of repose is about 30 to 65°, preferably about 32 to 60°, and more preferably about 35 to 55° (e.g., about 40 to 50°) in accordance with JIS (Japanese Industrial Standards) R9301-2-2. Moreover, the whole copolyamide-series resin particle (or powdery sealant) may have an angle of rupture of, for example, about 10 to 30°, preferably about 12 to 28°, and more preferably about 15 to 25°. The angle of repose and the angle of rupture can be measured using a conventional apparatus (for example, Powder Tester PT-E manufactured by Hosokawa Micron Corporation). According to the present invention, the whole copolyamide-series resin particle can have a large angle difference [(angle of repose)-(angle of rupture)] and can stably be accumulated on a device or a substrate.

The copolyamide-series resin particle is not particularly limited to a specific form (or shape), and may be, for example, an amorphous form (such as pulverized matter), a spherical form, an ellipsoidal form, and others.

The copolyamide-series resin constituting the copolyamide-series resin particle includes a copolyamide (a thermoplastic copolyamide) and a polyamide elastomer.

The thermoplastic copolyamide may be an alicyclic copolyamide and usually an aliphatic copolyamide. The copolyamide may be formed by combination of a diamine component, a dicarboxylic acid component, a lactam component, and an aminocarboxylic acid component. The combination of the diamine component and the dicarboxylic acid component forms an amide bond of the copolyamide; each of the lactam component and the aminocarboxylic acid component can independently form an amide bond of the copolyamide. Thus, a pair of components (combination of a diamine component and a dicarboxylic acid component), a lactam component, and an aminocarboxylic acid component each may be referred to as an amide-forming component. From these viewpoints, the copolyamide can be obtained by copolymerization of a plurality of amide-forming components selected from the group consisting of a pair of components (combination of a diamine component and a dicarboxylic acid component), a lactam component, and an aminocarboxylic acid component. Moreover, the copolyamide can be obtained by copolymerization of at least one amide-forming component selected from the group consisting of a pair of components (combination of a diamine component and a dicarboxylic acid component), a lactam component and an aminocarboxylic acid component, and another amide-forming component different in kind from the above amide-forming component (or being the same kind as the above amide-forming component but different in the carbon number from the above amide-forming component). Moreover, the lactam component and the aminocarboxylic acid component may be presumed as an equivalent component as far as these components have the same carbon number and chain structure such as a branched structure. Thus, assuming that the pair of components composed of the diamine component and the dicarboxylic acid component is a first amide-forming component and that at least one of the lactam component and the aminocarboxylic acid component is a second amide-forming component, the copolyamide may for example be the following: a copolyamide of the first amide-forming component (the diamine component and the dicarboxylic acid component), wherein at least one of the diamine component and the dicarboxylic acid component comprises a plurality of components with different carbon number; a copolyamide of the first amide-forming component (the diamine component and the dicarboxylic acid component) and the second amide-forming component (at least one component selected from the group consisting of the lactam component and the aminocarboxylic acid component); a copolyamide of the second amide-forming component (at least one component selected from the group consisting of the lactam component and the aminocarboxylic acid component), wherein one of the lactam component and the aminocarboxylic acid component comprises a plurality of components with different carbon number; and a copolyamide of the lactam component and the aminocarboxylic acid component, wherein these components are the same or different in the carbon number from each other.

The diamine component may include an aliphatic diamine or alkylenediamine component (for example, a C₄₋₁₆alkylenediamine such as tetramethylenediamine, hexamethylenediamine, trimethylhexamethylenediamine, octamethylenediamine, or dodecanediamine), and others. These diamine components may be used singly or in combination. The preferred diamine component contains at least an alkylenediamine (preferably a C₆₋₁₄alkylenediamine, more preferably a C₅₋₁₂alkylenediamine).

If necessary, the diamine component may further contain an alicyclic diamine component {for example, a diaminocycloalkane such as diaminocyclohexane (e.g., a diaminoC₅₋₁₀cycloalkane); a bis(aminocycloalkyl)alkane [e.g., a bis(aminoC₅₋₈cycloalkyl)C₁₋₃alkane] such as bis(4-aminocyclohexyl)methane, bis(4-amino-3-methylcyclohexyl)methane, or 2,2-bis(4'-aminocyclohexyl)propane; a hydrogenated xylylenediamine} or an aromatic diamine component (e.g., m-xylylenediamine). The above diamine component (for example, an alicyclic diamine component) may have a substituent such as an alkyl group (a C₁₋₄alkyl group such as methyl group or ethyl group).

The proportion of the alkylenediamine component in the total diamine component may be about 50 to 100% by mol, preferably about 60 to 100% by mol (e.g., about 70 to 97% by mol), and more preferably about 75 to 100% by mol (e.g., about 80 to 95% by mol).

The dicarboxylic acid component may include an aliphatic dicarboxylic acid or alkanedicarboxylic acid component [for example, a dicarboxylic acid having about 4 to 36 carbon atoms or a C₄₋₃₆alkanedicarboxylic acid (such as adipic acid, pimelic acid, azelaic acid, sebacic acid, dodecanedioic acid, dimer acid or a hydrogenated product thereof)]. These dicarboxylic acid components maybe used singly or in combination. The preferred dicarboxylic acid component contains a C₆₋₃₆alkanedicarboxylic acid (for example, a C₆₋₁₆alkanedicarboxylic acid, preferably a C₈₋₁₄alkanedicarboxylic acid). If necessary, the dicarboxylic acid component may further contain an alicyclic dicarboxylic acid component (for example, a C₅₋₁₀cycloalkane-dicarboxylic acid such as cyclohexane-1,4-dicarboxylic acid or cyclohexane-1,3-dicarboxylic acid) or an aromatic dicarboxylic acid (such as terephthalic acid or isophthalic acid). An alicyclic polyamide resin obtained from the alicyclic diamine component and/or the alicyclic dicarboxylic acid component in combination with the aliphatic diamine component and/or the aliphatic dicarboxylic acid component, as the diamine component and the dicarboxylic acid component, is known as a transparent polyamide having a high transparency.

The proportion of the alkanedicarboxylic acid component in the total dicarboxylic acid component may be about 50 to 100% by mol, preferably about 60 to 100% by mol (e.g., about 70 to 97% by mol), and more preferably about 75 to 100% by mol (e.g., about 80 to 95% by mol).

In the first amide-forming component, the diamine component can be used in the range of about 0.8 to 1.2 mol and preferably about 0.9 to 1.1 mol relative to 1 mol of the dicarboxylic acid component.

The lactam component may include, for example, a C₄₋₂₀lactam such as δ-valerolactam, ε-caprolactam, ω-heptalactam, ω-octalactam, ω-decanelactam, ω-undecanelactam, or ω-laurolactam (or ω-laurinlactam). The aminocarboxylic acid component may include, for example, a C₆₋₂₀aminocarboxylic acid such as ω-aminodecanoic acid, ω-aminoundecanoic acid, or ω-aminododecanoic acid. These lactam components and aminocarboxylic acid components may also be used singly or in combination.

The preferred lactam component contains a C₆₋₁₉lactam, preferably a C₈₋₁₇lactam, and more preferably a C₁₀₋₁₅lactam (e.g., laurolactam). Moreover, the preferred aminocarboxylic acid contains an aminoC₆₋₁₉alkanecarboxylic acid, preferably an aminoC₈₋₁₇alkanecarboxylic acid, and more preferably an aminoC₁₀₋₁₅alkane carboxylic acid (such as amino undecanoic acid or aminododecanoic acid).

The copolyamide may be a modified polyamide such as a polyamine having a branched chain structure formed by introduction of a small amount of a polycarboxylic acid component and/or a polyamine component.

The ratio (molar ratio) of the first amide-forming component (combination of both the diamine component and the dicarboxylic acid component) relative to the second amide-forming component (at least one amide-forming component selected from the group consisting of the lactam component and the aminocarboxylic acid component) can be selected from the range of 100/0 to 0/100 in a ratio of the former/the latter, and may for example be about 90/10 to 0/100 (e.g., about 80/20 to 5/95), preferably about 75/25 to 10/90 (e.g., about 70/30 to 15/85), and more preferably about 60/40 to 20/80 in a ratio of the former/the latter.

Further, the copolyamide preferably contains a long-chain component having a long fatty chain [a higher (or long-chain) alkylene group or alkenylene group] as a polymer unit (or contains a unit derived from the long-chain component). The long-chain component may include a component having a long fatty chain or alkylene group with about 8 to 36 carbon atoms (preferably a C₈₋₁₆alkylene group, and more preferably a C₁₀₋₁₄alkylene group). As the long-chain component, for example, there may be mentioned at least one component selected from the group consisting of a C₈₋₁₈alkanedicarboxylic acid (e.g., preferably a C₁₀₋₁₆alkanedicarboxylic acid, and more preferably a C₁₀₋₁₄alkanedicarboxylic acid), a C₉₋₁₇lactam (preferably a C₁₁₋₁₅lactam such as laurolactam), and an aminoC₉₋₁₇alkanecarboxylic acid (preferably an aminoC₁₁₋₁₅alkanecarboxylic acid such as aminoundecanoic acid or aminododecanoic acid). These long-chain components may be used singly or in combination. Among these long-chain components, a practically used component includes the lactam component and/or the aminoalkanecarboxylic acid component, for example, at least one component selected from the group consisting oflaurolactam,aminoundecanoic acid,and aminododecanoic acid. The copolyamide containing a unit derived from the long-chain component has high water resistance as well as excellent adhesion to an electronic device, excellent abrasion resistance, and excellent impact resistance, and therefore protects an electronic device effectively.

The proportion of the long-chain component in the total monomer components for forming the copolyamide may be about 10 to 100% by mol (e.g. , about 25 to 95% by mol), preferably about 30 to 90% by mol (e.g., about 40 to 85% by mol), and more preferably about 50 to 80% by mol (e.g. , about 55 to 75% by mol).

Further, the copolyamide may be a multiple copolymer of the above amide-forming components, for example, anyone of a binary copolymer to a quinary copolymer. The copolyamide is usually any one of a binary copolymer to a quaternary copolymer, and particularly a binary copolymer or a ternary copolymer.

The copolyamide practically contains, for example, an amide-forming component (an amide-forming component for forming a polyamide) selected from the group consisting of a polyamide 11, a polyamide 12, a polyamide 610, a polyamide 612, and a polyamide 1010 as a constitutional unit (or contains a unit derived from the above amide-forming component). The copolyamide may be a copolymer of a plurality of the amide-forming components or may be a copolymer of one or a plurality of the amide-forming components and another amide-forming component (e.g., at least one amide-forming component for forming a polyamide selected from the group consisting of a polyamide 6 and a polyamide 66). Specifically, the copolyamide includes, for example, a copolyamide 6/11, a copolyamide 6/12, a copolyamide 66/11, a copolyamide 66/12, a copolyamide 610/11, a copolyamide 612/11, a copolyamide 610/12, a copolyamide 612/12, a copolyamide 1010/12, a copolyamide 6/11/610, a copolyamide 6/11/612, a copolyamide 6/12/610, and a copolyamide 6/12/612. In these copolyamides, each component separated by the slash "/" indicates an amide-forming component.

As the polyamide elastomer (polyamide block copolymer), there may be mentioned a polyamide block copolymer composed of a polyamide as a hard segment (or a hard block) and a soft segment (or a soft block), for example, a polyamide-polyether block copolymer, a polyamide-polyester block copolymer, and a polyamide-polycarbonate block copolymer.

The polyamide constituting the hard segment may be a homo- or co-polymer (a homopolyamide or a copolyamide) formed by one or a plurality of the above amide-forming components. The homopolyamide as the hard segment may contain the above-exemplified long-chain component as a constitutional unit. The preferred long-chain component includes the same as one described above. Arepresentative homopolyamide includes a polyamide 11, a polyamide 12, a polyamide 610, a polyamide 612, a polyamide 1010, a polyamide 1012, and others. Moreover, the copolyamide as the hard segment includes the same as the above-exemplified copolyamide. Among these polyamides, the preferred polyamide includes a homopolyamide (such as a polyamide 11, a polyamide 12, a polyamide 1010, or a polyamide 1012).

A representative polyamide elastomer includes a polyamide-polyether block copolymer. In the polyamide-polyether block copolymer, the polyether (polyetherblock) mayinclude, for example, apoly(alkylene glycol) [e.g., a poly(C₂₋₆alkylene glycol), preferably a poly(C₂₋₄alkylene glycol), such as a poly (ethylene glycol), a poly(propylene glycol), or a poly(tetramethylene glycol)].

As examples of the polyamide-polyether block copolymer, there may be mentioned a block copolymer obtainable by copolycondensation of a polyamide block having a reactive terminal group and a polyether block having a reactive terminal group, for example, a polyetheramide [e.g., a block copolymer of a polyamide block having a diamine end and a poly(alkylene glycol) block (or a polyoxyalkylene block) having a dicarboxyl end, and a block copolymer of a polyamide block having a dicarboxyl end and a poly(alkylene glycol) block (or a polyoxyalkylene block) having a diamine end]; and a polyetheresteramide [e.g., ablockcopolymerofapolyamide block having a dicarboxyl end and a poly (alkylene glycol) block (or a polyoxyalkylene block) having a dihydroxy end] . The polyamide elastomer may have an ester bond. In order to improve the acid resistance, the polyamide elastomer may be free from an ester bond. Moreover, a commercially available polyamide elastomer usually has no or few amino group.

In the polyamide elastomer (the polyamide block copolymer), the number average molecular weight of the soft segment (e.g. , a polyether block, a polyester block, and a polycarbonate block) may be selected from the range of, e.g. , about 100 to 10000, and may be preferably about 300 to 6000 (e.g., about 300 to 5000), more preferably about 500 to 4000 (e.g. , about 500 to 3000), and particularly about 1000 to 2000.

Moreover, in the polyamide elastomer (the polyamide block copolymer), the ratio (weight ratio) of the polyamide block (polyamide segment) relative to the soft segment block may for example be about 75/25 to 10/90, preferably about 70/30 to 15/85, and more preferably about 60/40 to 20/80 (e.g., about 50/50 to 25/75) in a ratio of the former/the latter.

These copolyamide-series resins maybe used singly or in combination. Among these copolyamide-series resins, in view of the ability to seal an electronic device, the copolyamide (a non-polyamide elastomer or a polyamide random copolymer) is preferred. In particular, it is preferred that the copolyamide contain an amide-forming component derived from a polyamide 12 as a constitutional unit.

The amino group concentration of the copolyamide-series resin is not particularly limited to a specific one, and may for example be about 10 to 300 mmol/kg, preferably about 15 to 280 mmol/kg, and more preferably about 20 to 250 mmol/kg.

The carboxyl group concentration of the copolyamide-series resin is not particularly limited to a specific one, and may for example about 10 to 300 mmol/kg, preferably about 15 to 280 mmol/kg, and more preferably about 20 to 250 mmol/kg. A high carboxyl group concentration of a copolyamide-series resin achieves high heat stability, which is advantageous.

The number average molecular weight of the copolyamide-series resin can be selected from the range of, e.g., about 5000 to 200000; and may for example be about 6000 to 100000, preferably about 7000 to 70000 (e.g., about 7000 to 15000), and more preferably about 8000 to 40000 (e.g., about 8000 to 12000); and is usually about 8000 to 30000. The molecular weight of the copolyamide-series resin can be measured by gel permeation chromatography using HFIP (hexafluoroisopropanol) as a solvent in terms of poly(methyl methacrylate).

The amide bond content per molecule of the copolyamide-series resin can be selected from the range of, for example, not more than 100 units. In respect of the ability to seal a device, the amide bond content may be about 30 to 90 units, preferably about 40 to 80 units, and more preferably about 50 to 70 units (e.g., about 55 to 60 units). The amide bond content can be calculated, for example, by dividing a number average molecular weight by a molecular weight of a repeating unit (1 unit).

The copolyamide-series resin may be amorphous (or non-crystalline) or may be crystalline. The copolyamide-seriesresin may have a degree of crystallinity of, for example, not more than 20% and preferably not more than 10%. The degree of crystallinity can be measured by a conventional method, for example, a measuring method based on density or heat of fusion, an X-ray diffraction method, and an absorption of infrared rays.

The thermal melting property of the amorphous copolyamide-series resin can be determined based on a softening temperature measured by a differential scanning calorimeter. The melting point of the crystalline copolyamide-series resin can be measured by a differential scanning calorimeter (DSC).

The copolyamide-series resin (or the copolyamide or the polyamide elastomer) may have a melting point or softening point of about 75 to 160°C (e.g., about 80 to 150°C), preferably about 90 to 140°C (e.g., about 95 to 135°C), and more preferably about 100 to 130°C; and is usually about 90 to 160°C (e.g., about 100 to 150°C). Because the copolyamide-series resin has a low melting point or softening point, the melted or molten resin is useful to follow an external shape (or a surface) of a device [e.g., an uneven surface of a device (such as a corner region forming a stepped section)]. When the copolyamide-series resin contains components compatible with each other to show a single peak by DSC, the melting point of the copolyamide-series resin means a temperature at the single peak; when the copolyamide-series resin contains components incompatible with each other to show a plurality of peaks by DSC, the melting point of the copolyamide-series resin means the highest temperature out of a plurality of temperature values showing the peaks.

The copolyamide-series resin preferably has a high melting flowability in order to follow an external shape (or surface) of a device (such as an uneven surface of a device) and to allow the copolyamide-series resin to enter in a gap (or a space) or other areas. The copolyamide-series resin may have a melt flow rate (MFR) of about 1 to 350 g/10 minutes, preferably about 3 to 300 g/10 minutes, andmorepreferablyabout 5 to 250 g/10 minutes at a temperature of 160°C under a load of 2.16 kg.

To the copolyamide-series resin, a homopolyamide (for example, a homopolyamide of a component for forming the copolyamide) may be added as far as the characteristics (such as adhesion) of the copolyamide-series resin are not damaged. The ratio of the homopolyamide may be not more than 30 parts by weight (e.g., about 1 to 25 parts by weight), preferably about 2 to 20 parts by weight, and more preferably about 3 to 15 parts by weight relative to 100 parts by weight of the copolyamide-series resin.

Moreover, if necessary, the copolyamide-series resin (or powdery sealant) may be used in combination with another resin, for example, a thermosetting resin (such as an epoxy resin) or a thermoplastic resin (such as an ethylene-vinyl acetate copolymer). The ratio of another resin relative to 100 parts by weight of the copolyamide-series resin may for example be about not more than 100 parts by weight (e.g., about 1 to 80 parts by weight), preferably about 2 to 70 parts by weight, more preferably about 2 to 50 parts by weight, and particularly not more than 30 parts by weight (e.g. , about 3 to 20 parts by weight). That is, the proportion of the copolyamide-series resin in the whole resin component of the powdery sealant may be about 50 to 100% by weight, preferably about 60 to 100% by weight (e.g., about 70 to 99.9% by weight), and more preferably about 80 to 100% by weight (e.g., about 90 to 99% by weight).

The copolyamide-series resin particle (the powdery mixture of the copolyamide-series resin) may be a mixture of each copolyamide particle or a mixture of a particle of a molten mixture of each copolyamide. In such a form of the mixture, each polyamide may have compatibility with each other. In a case where the particle size distribution that shows the relationship between the particle diameter and the frequency in the copolyamide-series resin particle has a plurality of peaks (particle group), the species of the copolyamide-series resin corresponding to each peak (particle group) may be the same or different.

If necessary, the powdery sealant (or copolyamide-series resin particle) of the present invention may contain various additives, for example, a filler, a stabilizer (such as a heat stabilizer or a weather-resistant stabilizer), a coloring agent, a plasticizer, a lubricant, aflame retardant, an antistatic agent, and a thermal conductive agent. The additives may be used alone or in combination. Among these additives, an additive such as the stabilizer or the thermal conductive agent is widely used.

In particular, the powdery sealant (or the copolyamide-series resin composition constituting the powdery sealant) of the present invention may contain the copolyamide-series resin and a hindered amine-series light stabilizer (HALS).

The hindered amine-series light stabilizer (HALS) is not particularly limited to a specific one as far as the sealing film of the copolyamide-series resin is prevented from weather-degrading. The HALS usually has a tetramethylpiperidine ring skeleton (for example, 2,2,6,6-tetramethylpiperidine ring skeleton).

The HALS can be divided into low-molecular-weight type and high-molecular-weight type. The low-molecular-weight HALS may include, for example, a tetramethyl piperidyl ester of a monocarboxylic acid [e.g., a C₂₋₆acyloxy-tetramethylpiperidine such as 4-acetoxy-2,2,6,6-tetramethylpiperidine; a (meth)acryloyloxy-tetramethylpiperidine such as 4-methacryloyloxy-2,2,6,6-tetramethylpiperidine; and a C₆₋₁₀aroyloxy-tetramethylpiperidine such as 4-benzoyloxy-2,2,6,6-tetramethylpiperidine], a tetramethylpiperidyl ester of a di- or poly-carboxylic acid [e.g., a tetramethylpiperidyl ester of a C₂₋₁₀aliphatic di- or poly-carboxylic acid, such as bis(2,2,6,6-tetramethyl-4-piperidyl) adipate, bis(2,2,6,6-tetramethyl-4-piperidyl) sebacate, bis(N-methyl-2,2,6,6-tetramethyl-4-piperidyl) sebacate, or tetrakis(2,2,6,6-tetramethyl-4-piperidyl) sebacate; and a tetramethylpiperidyl ester of a C₆₋₁₀aromatic di-or poly-carboxylic acid, such as bis(2,2,6,6-tetramethyl-4-piperidyl) terephthalate], a tetramethyl piperidylamide of a di- or poly-carboxylic acid [e.g., a di (tetramethylpiperidylaminocarbonyl) C₁₋₄alkane such as N,N'-bis(2,2,6,6-tetramethyl-4-piperidyl)-1,2-ethanedicarboxyamide; and a di(tetramethyl piperidyl aminocarbonyl) C₆₋₁₀arene such as N,N'-bis(2,2,6,6-tetramethyl-4-piperidyl)-1,3-benzenedicarboxyamide], and a di(tetramethylpiperidyloxy)alkane [e.g., a di(tetramethyl piperidyloxy)C₁₋₄alkane such as 1,2-bis(2,2,6,6-tetramethyl-4-piperidyloxy)ethane].

The high-molecular-weight HALS may include, for example, a polyester of a dicarboxylic acid (e.g., a C₂₋₆alkanedicarboxylic acid such as malonic acid, succinic acid, or glutaric acid; and a C₆₋₁₀arenedicarboxylic acid such as phthalic acid, isophthalic acid, or terephthalic acid) and a diol having a tetramethylpiperidine ring skeleton (e.g., a tetramethylpiperidine having two hydroxyl-containing groups (e.g., hydroxyl groups, hydroxyalkyl groups), such as N-hydroxyethyl-2,2,6,6-tetramethyl-4-hydroxypiperidine); and a straight- or branched-chain compound containing a triazine unit (e.g. , 1,3,5-triazine unit) and an N,N'-bis(tetramethylpiperidyl)-alkanediamine unit (e.g., an N,N'-bis(2,2,6,6-tetramethyl-4-piperidyl)-C₂-₆alkanediamine unit) (e.g., "Tinuvin 622LD", "Chimassorb119", "Chimassorb 944", and "Chimassorb 2020", each manufactured by BASF). The number average molecular weight of the high-molecular-weight HALS is not particularly limited to a specific one and may for example be about 1500 to 5000 and preferably about 2000 to 4000 in terms of polystyrene in a gel permeation chromatography.

These HALSs may be used alone or in combination. For example, different low-molecular-weight HALSs may be used in combination, different high-molecular-weight HALSs maybe used in combination, or a low-molecular-weight HALS and a high-molecular-weight HALS may be used in combination.

The ratio of the HALS relative to 100 parts by weight of the copolyamide-series resin may be, for example, about 0.05 to 5 parts by weight, preferably about 0.1 to 2 parts by weight, and more preferably about 0.15 to 1.5 parts by weight (e.g., about 0.2 to 1 part by weight). A copolyamide-series resin composition containing the HALS at an excessively small ratio cannot be improved in prevention of weather degradation. A copolyamide-series resin composition containing the HALS at an excessively large ratio has a reduced strength and provides a sealing film easily generating cracks, and the sealing film has a low adhesion to a device or a substrate or a low sealing performance.

The HALS (a first light stabilizer as a radical scavenger) may be used in combination with a second light stabilizer. The second light stabilizer may include an ultraviolet ray absorbing agent (a light stabilizer as a radical-polymerization inhibitor), for example, a benzylidenemalonate-series ultraviolet ray absorbing agent [e.g., a dialkyl ester of benzylidenemalonic acid or a tetraalkyl ester of phenylenebis(methylenemalonic acid), each of which may have a substituent (such as an alkoxy group)], an oxanilide-series ultraviolet ray absorbing agent [e.g., an oxanilide having a substituent (such as an alkyl group or an alkoxy group)], a benzotriazole-series ultraviolet ray absorbing agent [e.g., a benzotriazole compound having a substituent (such as a hydroxy-alkyl-aryl group or a hydroxy-aralkyl-aryl group)], a benzophenone-series ultraviolet ray absorbing agent [e. g. , a hydroxybenzophenone compound which may have a substituent (such as an alkoxy group)], and a triazine-series ultraviolet ray absorbing agent [e.g., a diphenyltriazine compound having a substituent (such as a hydroxy-alkoxy-aryl group)]. These second light stabilizers may be used alone or in combination. Among these second light stabilizers, a preferred one includes a benzylidenemalonate-series ultraviolet ray absorbing agent [for example, a benzene having at least one di(C₁₋₄alkoxycarbonyl)vinyl group, such as dimethyl-4-methoxybenzylidenemalonate or tetraethyl-2,2'-(1,4-phenylene-dimethylidene)-bismalonate], an oxanilide-series ultraviolet ray absorbing agent [for example, an oxanilide having a C₁₋₄alkyl group and/or a C₁₋₄alkoxy group, such as N-(2-ethoxyphenyl)-N'-(2-ethylphenyl)-ethanediamide], a benzotriazole-series ultraviolet ray absorbing agent [for example, a benzotriazole having a hydroxy-(C₆₋₁₀aryl-straight- or branched-chain C₁₋₆alkyl)-C₆₋₁₀aryl group, such as 2- [2'-hydroxy-3',5'-bis(α,α-dimethylbenzyl)phenyl]benzotriazole].

The ratio of the second light stabilizer (e.g., an ultraviolet ray absorbing agent) relative to 100 parts by weight of the copolyamide-series resin may be, for example, about 0.01 to 5 parts by weight, preferably about 0.05 to 2 parts by weight, and more preferably about 0.1 to 1 part by weight (e.g. , about 0.1 to 0.5 parts by weight) . Moreover, the ratio of the second light stabilizer (e.g. , an ultraviolet ray absorbing agent) relative to 1 part by weight of the HALS may be, for example, selected from the range of about 0.1 to 10 parts by weight and may be about 0.2 to 5 parts by weight and preferably about 0.5 to 2 parts by weight (e. g. , about 0.8 to 1. 2 parts by weight) .

In terms of improvement of heat resistance, the HALS may be used in combination with a heat stabilizer (or an antioxidant). The heat stabilizer is usually a phenolic heat stabilizer in practical cases. The phenolic heat stabilizer may include a hindered phenolic heat stabilizer, for example, a monocyclic hindered phenol compound (e.g., 2,6-di-t-butyl-p-cresol), a polycyclic hindered phenol compound having a chain or cyclic hydrocarbon group as a linking group [for example, a C₁₋₁₀alkylenebis- to tetrakis(t-butylphenol) compound (e.g., 4,4'-methylenebis(2,6-di-t-butylphenol)); and a C₆₋₂₀arylenebis- to tetrakis(t-butylphenol) compound (e.g., 1,3,5-trimethyl-2,4,6-tris(3,5-di-t-butyl-4-hydroxybenzyl)benzene)], a polycyclic hindered phenol compound having an ester-containing group as a linking group [for example, a bis- to tetrakis(t-butylphenol) compound having a linking group that is a C₂₋₁₀alkyl chain or (poly)C₂₋₄alkoxyC₂₋₄alkyl chain with two to four C₂₋₁₀alkylenecarbonyloxy groups as substituents (e.g., 1,6-hexanediol-bis[3-(3,5-di-t-butyl-4-hydroxyphenyl) propionate], triethylene glycol-bis[3-(3-t-butyl-5-methyl-4-hydroxyphenyl)propionate], and pentaerythritol-tetrakis[3-(3,5-di-t-butyl-4-hydroxyphenyl)propionate]); and a bis- to tetrakis(t-butylphenol) compound having a linking group that is a hetero ring with two to four C₂₋₁₀alkylenecarbonyloxy groups as substituents (e.g., 3,9-bis[2-{3-(3-t-butyl-4-hydroxy-5-methylphenyl)propionyloxy}-1,1-dimethylethyl]-2,4,8,10-tetraoxaspiro[5.5]undecane)], and a polycyclic hindered phenol compound having an amide-containing group as a linking group [for example, a bis- to tetrakis(t-butylphenol) compound having a linking group that is a C₂₋₁₀alkyl chain with two to four C₂₋₁₀alkylenecarbonylamino groups as substituents (e.g., N,N'-ethylenebis[3-(3,5-di-t-butyl-4-hydroxyphenyl) propionamide], N,N'-tetramethylenebis[3-(3,5-di-t-butyl-4-hydroxyphenyl)propionamide], and N,N'-hexamethylenebis[3-(3,5-di-t-butyl-4-hydroxyphenyl)propionamide])]. These phenolic heat stabilizers may be used alone or in combination. The phenolic heat stabilizer may be used in combination with a phosphorus-containing heat stabilizer, a sulfur-containing heat stabilizer, or others.

The ratio of the heat stabilizer relative to 100 parts by weight of the copolyamide-series resin may be about 0.01 to 5 parts by weight, preferably about 0.05 to 2 parts by weight, and more preferably about 0.1 to 1 part by weight (e.g. , about 0.2 to 0.8 parts by weight). Moreover, the ratio of the heat stabilizer relative to 1 part by weight of the HALS may be, for example, selected from the range of about 0.1 to 10 parts by weight and may be about 0.1 to 5 parts by weight and preferably about 0. 5 to 4 parts by weight (e.g. , about 1 to 3 parts by weight).

As described above, the powdery sealant of the present invention may comprise a particulate copolyamide-series resin, a particulate mixture of a plurality kind of copolyamide-series resins, or a particulate mixture (copolyamide-series resin composition) containing a copolyamide-series resin and another component (e.g., a homopolyamide, another resin, an additive).

The powdery or particulate sealant may be produced by pulverization using a conventional method (for example, freeze pulverization) and classification using a sieve or other means.

Moreover, the powdery or particulate sealant containing the HALS may be produced by, for example, preparing a copolyamide-series resin composition and pulverizing the composition using freeze pulverization or other methods, and if necessary, classifying the resulting matter using a sieve or other means; wherein the copolyamide-series resin composition may be prepared by the inclusion of an HALS in a copolyamide-series resin (e.g., mixing or kneading of a copolyamide-series resin andanHALS, or applying (or immersion) of alight stabilizer to (or in) a copolyamide-series resin at a temperature higher than a glass transition temperature of the resin) . In a case where the copolyamide-series resin composition is prepared by melt-kneading each component, the melt-kneading temperature may be, for example, about 100 to 250°C, preferably about 120 to 220°C, and preferably about 150 to 200°C.

Use of the copolyamide-series resin in the form of a particulate having a specified particle size distribution as a sealant allows (1) a powder flowability (or fluidity) by which the resin is capable of flowing on a surface of a device and can stably and efficiently be accumulated without dropping out in a case where the resin is spread (or sprinkled) on a device or a substrate, (2) rapid melting of the resin at a low temperature, and (3) shortening of sealing and molding cycles compared with a thermosetting resin. Moreover, (4) although a film sealant cannot follow an uneven surface or a surface having depressed and raised portions (in particular, a surface having acutely or markedly depressed and raised portions), the powdery sealant can easily follow the surface having depressed and raised portions to allow covering or sealing the surface; (5) in an injection molding (in particular, a low-pressure injection molding) or a molding of a hot-melt resin, there is a limitation in the size of a device or substrate in connection with a mold, and only a device or substrate having a size of about 10 cm x 10 cm at the most can be sealed. In contrast, the powdery sealant can seal a device without limitation in the size of the device. Further, (6) differently from the injection molding or the molding of the hot-melt resin, the powdery sealant even in a thin layer form surely molds to a device and thus can be lightweight and small-sized, and (7) the powdery sealant ensures molding of a device with high adhesion and high seal-ability. Thus, the powdery sealant can thermally adhere to an electronic device or the like, thereby protecting the device against water, moisture, contamination due to adhesion of dust, and others. In particular, the powdery sealant containing a copolyamide-series resin improves adhesion to the device, imparts a high impact resistance and abrasion resistance to the device, and improves a protective effect relative to the device. Furthermore, (8) use as a sealant of the resin composition containing the copolyamide-series resin and the HALS and having a particulate form can effectively prevent degradation (e.g., rough surface, defective appearance) of a sealing film due to weather.

According to the method of the present invention, a device covered or molded with a copolyamide-series resin can be produced by a step for applying (or spreading) the powdery sealant on at least part (a region) of a device, a step for heat-melting the powdery sealant, and cooling the powdery sealant.

The device may include various organic or inorganic devices, each requiring molding or sealing, for example, a precision part (e.g., a semiconductor element, an electroluminescent (EL) device, a light emitting diode, and a solar cell) or an electronic part (in particular, a precision electronic part or an electronic device) such as a circuit board (a printed wiring board) equipped or mounted with a part (such as various electronic parts or electronic devices).

In the applying step, the powdery sealant may be applied or spread (sprinkled or sprayed) on the whole of the device, or the device may optionally be masked and then the powdery sealant maybe applied or spread (sprinkled or sprayed) on only a predetermined site. The powdery sealant may be attached to the device by immersing (flow-immersing) the device in the powdery sealant. Since the powdery sealant has a moderate powder flowability and can efficiently be accumulated on a predetermined site of a device, it is preferred to attach the powdery sealant to a device by spreading (or spraying) the powdery sealant on the device placed on a predetermined member. Incidentally, a large amount of the powdery sealant may be applied or attached to a predetermined portion (for example, a risingportion or a corner portion) of the device. Moreover, the device may be coated with a volatile liquid in order to retain (or hold) the powdery sealant on the device temporarily. Further, if necessary, the device may be heated (for example, heated to a temperature not lower than the melting point or softening point of the sealant) for attaching (or partially melt-attaching) the powdery sealant to the device. In this case, an excess amount of the powdery sealant maybe removed by vibration, revolution (or rolling), wind force, or other means.

Moreover, in order to uniformly attach the powdery sealant to the device, the powdery sealant may be spread on or attached to the device by forming a fluidized bed of the powdery sealant in a container while feeding air from a bottom porous plate of the container, and immersing the device (optionally heated) in the fluid bed. Further, in order to attach the powdery sealant to details of the device, the powdery sealant may be spread on or attached to the device while rotating the device.

The amount (attached amount) of the powdery sealant maybe selected depending on the molding or covering amount, and may for example be about 0.1 to 100 mg/cm², preferably about 0.5 to 50 mg/cm², and more preferably 1 to 30 mg/cm².

In the heating step, the copolyamide-series resin adheres (or melt-adheres) to the device by heat-melting the powdery sealant depending on the heat resistance of the device. The heating temperature may for example be about 75 to 200°C, preferably about 80 to 180°C, and more preferably about 100 to 175°C (e.g., about 110 to 150°C) depending on the melting point or softening point of the copolyamide-series resin. The heating can be carried out in air or in an inert gas atmosphere. The heating can be conducted in an oven, and if necessary, may use ultrasonic heating or high-frequency heating (electromagnetic heating). The heat-melting step may be carried out under an atmospheric pressure or an applied pressure. If necessary, the heat-melting step may be carried out under a reduced-pressure condition for defoaming.

Further, if necessary, the applying step and the heating step may be repeated. Moreover, after a copolyamide-series resin layer is formed on a first side (e.g. , an upper surface) of the device as described above, a second side (e.g., a bottom surface) of the device is applied or sprinkled with the powdery sealant for molding and sealing both sides of the device including end faces thereof.

In the cooling step, the molten (or melt-adhered) copolyamide-series resin may be cooled spontaneously, or stepwise or continuously, or rapidly.

By these steps, a device at least a region of which is covered or molded with the copolyamide-series resin layer formed by heat-melting (or thermal adhesion) of the powdery sealant can be obtained. The molding site of the device is usually a fragile or delicate site, for example, a site equipped with an electronic device and a wiring site.

According to the present invention, since the powdery sealant can be melted to adhere to the device at a relatively low temperature, the reliability of the device can be improved due to a low thermal damage to the device. Moreover, differently from injection molding or the like, since a high pressure is not applied to the device, the device is not damaged due to a pressure. Thus, the sealant molds and seals the device with high reliability. In addition, the heating and cooling in a short period of time improves the production of the molded or sealed device greatly.

### EXAMPLES

The following examples are intended to describe this invention in further detail and should by no means be interpreted as defining the scope of the invention. The methods of the evaluation of evaluation items in the examples are as follows. In the examples, the term "part" means "part by weight" unless otherwise noted.

[Particle size distribution and average particle diameter]

Each of powdery resin particle samples obtained in Examples and Comparative Examples was measured for the particle size distribution and the average particle diameter using a laser diffraction apparatus (HORIBALA920, manufactured by Horiba, Ltd.).

### [Angle of repose]

Each of powdery resin particle samples obtained in Examples and Comparative Examples was tested for the angle of repose, as follows. In accordance with JIS R9301-2-2, the powdery resin particle sample (200 g) was poured onto a horizontal metallic table (radius: 4 cm) through a distance of 9 cm from a glass funnel (maximum internal diameter of upper part: 70 mm; internal diameter of bottom part x length thereof: 5 mm x 50 mm) to form a conical pile on the metallic table. The angle (external angle) between the generator (surface) of the conical pile and the surface of the metallic table was measured with a protractor, and the base angle (angle of repose) of the conical pile was calculated.

### [Angle of rupture]

The angle of rupture was measured using "Powder Tester PT-E" manufactured by Hosokawa Micron Corporation.

### [Melting time]

Each of powdery resin particle samples obtained in Examples and Comparative Examples was tested for the melting time, as follows. A glass plate having a size of 26 mm x 76 mm was placed on an iron plate (thickness: 1 mm). The powdery resin particle sample (0.2 g) was spread on the center of the glass plate in such a manner as not to have the sample spilled out. The resulting test specimen was placed in an oven at 170°C, and the time required to give a flat surface of the sample was measured.

### [Sealing performance]

The sealing performance of a sealant was evaluated for both of a flat surface of a substrate and a protruded portion having a side face (height: 2 mm or 20 mm) rising perpendicularly from a flat surface of a substrate on the basis of the following criteria.
5: The flat surface or the protruded portion is wholly covered with the sealant.
4: The flat surface or the protruded portion is almost wholly covered, but entering of air is partly observed between the substrate and the sealant.
3: Half of the sealant peels off from the flat surface or the protruded portion.
2: The sealant partly adheres to the flat surface or the protruded portion, but the sealant mostly peels off from the flat surface or the protruded portion.
1: The sealant wholly peels off from the flat surface or the protruded portion.

### [Peel test]

A test piece comprising a glass epoxy substrate sealed with a sealant of Examples and Comparative Examples was evaluated for the adhesion between the substrate and the film according to a cross-cut test.

### [Water resistance test]

A test piece comprising a glass epoxy substrate sealed with a sealant of Examples and Comparative Examples was evaluated for the water resistance according to a cross-cut test after being immersed in water of a thermostatic bath at 23°C for 100 hours.

### [LED lighting test]

Each of sealants obtained in Examples and Comparative Examples was tested for LED lighting test, as follows. A LED-mounting substrate sealed with the sealant was immersed in water at 23°C for 100 hours, and then a current was applied to the substrate. If the LED was on, the sealant was graded "A"; if the LED was off, the sealant was graded "B".

### [Weather resistance test]

Each of sealants obtained in Examples was tested for weather resistance test, as follows. A glass epoxy substrate mounted with LED was sealed with the sealant to give a sample, and 10 samples every sealant was prepared. After the samples were exposed using a xenon weather meter for 1000 hours, the weather resistance was evaluated according to the number of substrates that LED was off.

### Example 1

A copolyamide (VESTAMELT X1051 manufactured by Evonik, containing a C₁₀₋₁₄alkylene group, melting point: 130°C (DSC), melt flow rate: 15 g/10 minutes (a temperature of 160°C and a load of 2.16 kg)) was freeze-pulverized and passed through a wire mesh (or wire gauze) (opening size: 60 µm) to give a powdery resin particle having an average particle diameter of 44 µm and a particle size of 0.5 to 60 µm. The resin particle was uniformly spread on an electronic substrate (200 mm x 200 mm) made of a glass epoxy resin using a wire mesh (opening size: 200 µm), and then heated under an atmosphere of a temperature of 170°C to give a substrate coated with the transparent resin.

### Example 2

A copolyamide (VESTAMELT X1051) was freeze-pulverized and passed through a wire mesh (opening size: 80 µm) to give a powdery resin particle having an average particle diameter of 49 µm and a particle size of 0.5 to 80 µm. The resin particle was uniformly spread on an electronic substrate (200 mm x 200 mm) made of a glass epoxy resin using a wire mesh (opening size: 200 µm), and then heated under an atmosphere of a temperature of 170°C to give a substrate coated with the transparent resin.

### Example 3

A copolyamide (VESTAMELT X7079 manufactured by Evonik, containing a C₁₀₋₁₄alkylene group, melting point: 130°C (DSC), melt flow rate: 3 g/10 minutes (a temperature of 160°C and a load of 2.16 kg)) was freeze-pulverized and passed through a wire mesh (opening size: 120 µm) to give a powdery resin particle having an average particle diameter of 78 µm and a particle size of 0.5 to 120 µm. The resin particle was uniformly spread on an electronic substrate (200 mm x 200 mm) made of a glass epoxy resin using a wire mesh (opening size: 250 µm), and then heated under an atmosphere of a temperature of 170°C to give a substrate coated with the transparent resin.

### Example 4

A copolyamide (VESTAMELT X7079) was freeze-pulverized and passed through a wire mesh (opening size: 160 µm) to give a powdery resin particle having an average particle diameter of 85 µm and a particle size of 0.5 to 160 µm. The resin particle was uniformly spread on an electronic substrate (200 mm x 200 mm) made of a glass epoxy resin using a wire mesh (opening size: 250 µm), and then heated under an atmosphere of a temperature of 170°C to give a substrate coated with the transparent resin.

### Example 5

A copolyamide (VESTAMELT X1051) was freeze-pulverized and passed through a wire mesh (opening size: 300 µm) to give a powdery resin particle having an average particle diameter of 183 µm and a particle size of 0.5 to 300 µm. The resin particle was uniformly spread on an electronic substrate (200 mm x 200 mm) made of a glass epoxy resin using a wire mesh (opening size: 500 µm), and then heated under an atmosphere of a temperature of 170°C to give a substrate coated with the transparent resin.

### Example 6

A copolyamide (VESTAMELT X1051) was freeze-pulverized and passed through a wire mesh (opening size: 500 µm) to give a powdery resin particle having an average particle diameter of 278 µm and a particle size of 0.5 to 500 µm. The resin particle was uniformly spread on an electronic substrate (200 mm x 200 mm) made of a glass epoxy resin using a wire mesh (opening size: 710 µm), and then heated under an atmosphere of a temperature of 170°C to give a substrate coated with the transparent resin.

### Example 7

A copolyamide (VESTAMELT X1051) was freeze-pulverized and passed through a wire mesh (opening size: 1000 µm) to give a powdery resin particle having an average particle diameter of 308 µm and a particle size of 0.5 to 1000 µm. The resin particle was uniformly spread on an electronic substrate (200 mm x 200 mm) made of a glass epoxy resin using a wire mesh (opening size: 710 µm), and then heated under an atmosphere of a temperature of 170°C to give a substrate coated with the transparent resin.

### Example 8

A copolyamide (VESTAMELT X1051) was freeze-pulverized and passed through two wire meshes (each opening size: 80 µm, 160 µm) to give a powdery resin particle having an average particle diameter of 148 µm and a particle size of 80 to 160 µm. The resin particle was uniformly spread on an electronic substrate (200 mm x 200 mm) made of a glass epoxy resin using a wire mesh (opening size: 300 µm), and then heatedunder an atmosphere of a temperature of 170°C to give a substrate coated with the transparent resin.

### Example 9

A copolyamide (VESTAMELT X1051) was freeze-pulverized and passed through two wire meshes (each opening size: 80 µm, 200 µm) to give apowdery resin particle having an average particle diameter of 169 µm and a particle size of 80 to 200 µm. The resin particle was uniformly spread on an electronic substrate (200 mm x 200 mm) made of a glass epoxy resin using a wire mesh (opening size: 300 µm), and then heated under an atmosphere of a temperature of 170°C to give a substrate coated with the transparent resin.

### Example 10

A copolyamide (VESTAMELT X1051) was freeze-pulverized and passed through two wire meshes (each opening size: 80 µm, 500 µm) to give a powdery resin particle having an average particle diameter of 340 µm and a particle size of 80 to 500 µm. The resin particle was uniformly spread on an electronic substrate (200 mm x 200 mm) made of a glass epoxy resin using a wire mesh (opening size: 710 µm), and then heated under an atmosphere of a temperature of 170°C to give a substrate coated with the transparent resin.

### Example 11

A copolyamide (VESTAMELT X1051) was freeze-pulverized and passed through two wire meshes (each opening size: 500 µm, 1000 µm) to give a first powdery resin particle having an average particle diameter of 617 µm and a particle size of 500 to 1000 µm. A copolyamide (VESTAMELTX1051) was freeze-pulverized and passed through a wire mesh (opening size: 200 µm) to give a second powdery resin particle having an average particle diameter of 160 µm and a particle size of 0.5 to 200 µm. The first resin particle (100 parts by weight) and the second resin particle (5 parts by weight) were mixed, and the mixture was uniformly spread on an electronic substrate (200 mm x 200 mm) made of a glass epoxy resin using a wire mesh (opening size: 710 µm), and then heated under an atmosphere of a temperature of 170°C to give a substrate coated with the transparent resin.

### Comparative Example 1

A copolyamide (VESTAMELT X1051) was freeze-pulverized and passed through a wire mesh (opening size: 1000 µm) to give a powdery resin particle having an average particle diameter of not smaller than 1300 µm and a particle size of larger than 1000 µm. The resin particle was uniformly spread on an electronic substrate (200 mm x 200 mm) made of a glass epoxy resin using a wire mesh (opening size: 2000 µm), and then heated under an atmosphere of a temperature of 170°C. The resin particle spilled from the substrate, and the substrate did not uniformly coated with the resin.

### Comparative Example 2

A copolyamide (VESTAMELT 350 manufactured by Evonik, containing a C₁₀₋₁₄alkylene group, spherical pellet having an average particle diameter of about 3000 µm, melting point: 105°C (DSC), melt flow rate: 15 g/10 minutes (a temperature of 160°C and a load of 2.16 kg)) was uniformly spread on an electronic substrate (200 mm x 200 mm) made of a glass epoxy resin and then heated under an atmosphere of a temperature of 170°C, but the substrate did not uniformly coated with the resin.

### Comparative Example 3

A polyamide 12 (DAIAMID A1709, manufactured by Daicel-Evonik Ltd., average particle diameter: 80 µm, particle size: 0.5 to 160 µm, melting point: 178°C (DSC), melt flow rate: 70 g/10 minutes (a temperature of 190°C and a load of 2.16 kg) was uniformly spread on an electronic substrate (200 mm x 200 mm) made of a glass epoxy resin, and then heated under an atmosphere of a temperature of 220°C to give a substrate coated with the transparent resin.

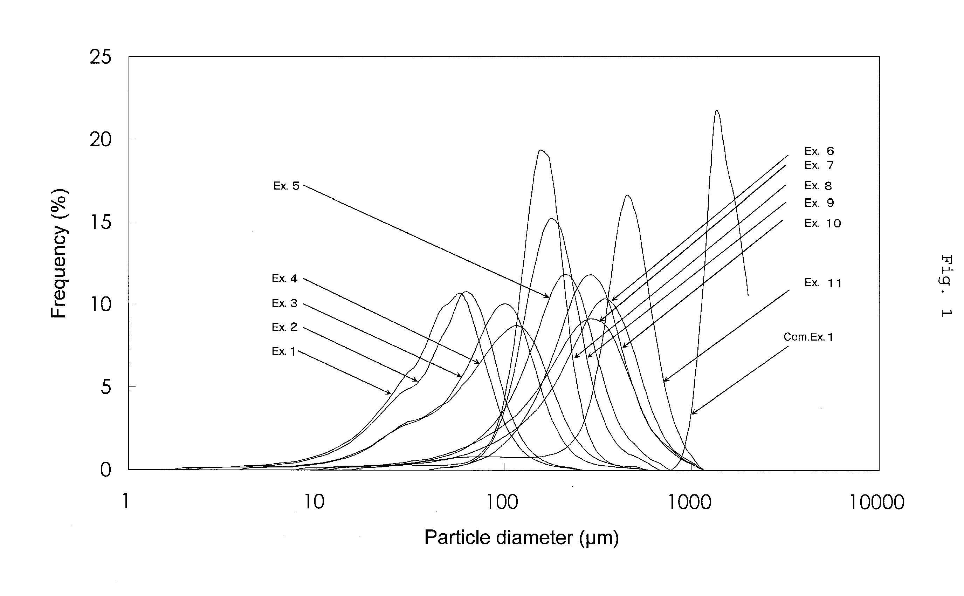

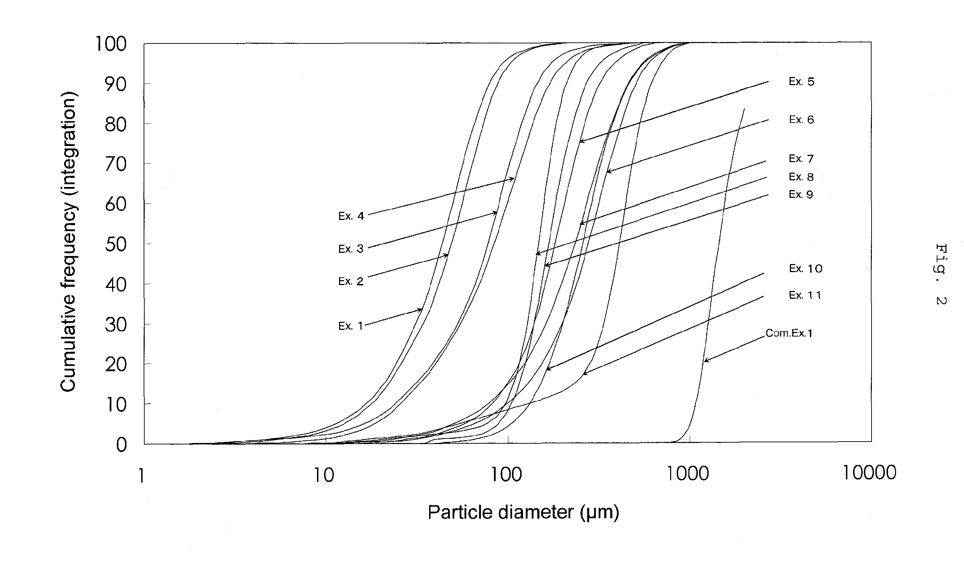

The physical properties of powdery resin particles obtained in Examples and Comparative Examples are shown in Table 1, the relationship between the particle diameter and the frequency thereof is shown in Fig. 1, and the relationship between the particle diameter and the cumulative percent passing is shown in Fig. 2. The measurement limit (upper limit) of the laser diffraction apparatus is 2 mm, and the frequency and cumulative percent passing of the powdery resin particle with a particle diameter of larger than 2 mm in Comparative Example 3 are omitted in Fig. 1 and Fig. 2.

[Table 1]

**Table 1**

| | | Particle size distribution (µm) | Average particle diameter (µm) | Angle of repose (°) | Angle of rupture (°) | Melting time (sec.) |
|---|---|---|---|---|---|---|
| Example 1 | VESTAMELT X1051 | 0.5 to 60 | 44 | 50 | - | 31 |
| Example 2 | VESTAMELT X1051 | 0.5 to 80 | 49 | 48 | 23 | 33 |
| Example 3 | VESTAMELT X7079 | 0.5 to 120 | 78 | 45 | - | 40 |
| Example 4 | VESTAMELT X7079 | 0.5 to 160 | 85 | 43 | - | 48 |
| Example 5 | VESTAMELT X1051 | 0.5 to 300 | 183 | 40 | - | 56 |
| Example 6 | VESTAMELT X1051 | 0.5 to 500 | 278 | 41 | 23 | 67 |
| Example 7 | VESTAMELT X1051 | 0.5 to 1000 | 308 | 38 | 24 | 75 |
| Example 8 | VESTAMELT X1051 | 80 to 160 | 148 | 38 | - | 74 |
| Example 9 | VESTAMELT X1051 | 80 to 200 | 169 | 39 | - | 75 |
| Example 10 | VESTAMELT X1051 | 80 to 500 | 340 | 38 | 23 | 81 |
| Example 11 | VESTAMELT X1051 | 0.5 to 200 500 to 1000 | 160 617 | 41 | 23 | 85 |
| Comparative Example 1 | VESTAMELT X1051 | 1000< | 1300≦ | - | - | 210 |
| Comparative Example 2 | VESTAMELT 350 | - | 3000 (spherical pellet) | 18 | - | 160 |
| Comparative Example 3 | DAIAMID A1709 | 0.5 to 160 | 80 | - | - | 55 |

[Table 2]

**Table 2**

| | Examples | | | | | | | | | | | Comparative Examples | | |
|---|---|---|---|---|---|---|---|---|---|---|---|---|---|---|
| | 1 | 2 | 3 | 4 | 5 | 6 | 7 | 8 | 9 | 10 | 11 | 1 | 2 | 3 |
| Flat | 5 | 5 | 5 | 5 | 5 | 5 | 5 | 5 | 5 | 5 | 5 | 4 | 2 | 5 |
| Protruded portion 2 mm | 5 | 5 | 5 | 5 | 5 | 5 | 5 | 5 | 5 | 5 | 5 | 3 | 2 | 3 |
| Protruded portion 20 mm | 5 | 5 | 5 | 5 | 5 | 5 | 5 | 5 | 5 | 5 | 5 | 3 | 1 | 3 |
| Peel test | 0 | 0 | 0 | 0 | 0 | 0 | 0 | 0 | 0 | 0 | 0 | 23 | unable | 100 |
| Water resistance test | 0 | 0 | 0 | 0 | 0 | 0 | 0 | 0 | 0 | 0 | 0 | 42 | unable | 100 |
| LED lighting test | A | A | A | A | A | A | A | A | A | A | A | B | B | B |

As apparent from Table 2, compared with Comparative Examples, Examples show high sealing performance in both the flat portion and the protruded portion as well as have excellent adhesion and water resistance.

### Example 12

To 100 parts of a copolyamide (VESTAMELT X1051 manufactured by Evonik, containing a C₁₀₋₁₄alkylene group, melting point: 130°C (DSC), melt flow rate: 15 g/10 minutes (a temperature of 160°C and a load of 2.16 kg)), 0.25 parts of a light stabilizer HALS (Tinuvin 622LD manufactured by BASF), 0 .25 parts of an ultraviolet ray absorbing agent (Tinuvin 234 manufactured by BASF), and 0.5 parts of a heat stabilizer (Sumilizer GA80 manufactured by Sumitomo Chemical Co., Ltd.) were added, and the mixture was compounded using TEX30 manufactured by JSW at 180°C. The resulting compound was freeze-pulverized and passed through a wire mesh (opening size: 160 µm) to give a powdery resin particle having an average particle diameter of 120 µm and a particle size of 0.5 to 160 µm. The resin particle was uniformly spread on an electronic substrate (200 mm x 200 mm) made of a glass epoxy resin using a wire mesh (opening size : 200 µm), and then heated under an atmosphere of a temperature of 170°C to give a substrate coated with the transparent resin.

### Example 13

To 100 parts of a copolyamide (VESTAMELT X1051), 0.5 parts of a light stabilizer HALS (NYLOSTAB S-EED manufactured by Clariant Ltd.) and 0.25 parts of an ultraviolet ray absorbing agent (HOSTAVIN B-CAP manufactured by Clariant Ltd.) were added, and the mixture was compounded using TEX30 manufactured by JSW at 180°C. The resulting compound was freeze-pulverized and passed through a wire mesh (opening size: 160 µm) to give a powdery resin particle having an average particle diameter of 120 µm and a particle size of 0.5 to 160 µm. The resin particle was uniformly spread on an electronic substrate (200 mm x 200 mm) made of a glass epoxy resin using a wire mesh (opening size : 200 µm), and then heated under an atmosphere of a temperature of 170°C to give a substrate coated with the transparent resin.

### Example 14

To 100 parts of a copolyamide (VESTAMELT X1051), 0.3 parts of a light stabilizer HALS (NYLOSTAB S-EED manufactured by Clariant Ltd.), 0.25 parts of an ultraviolet ray absorbing agent (HOSTAVIN PR25 manufactured by Clariant Ltd.), and 0.5 parts of a heat stabilizer (Sumilizer GA80 manufactured by Sumitomo Chemical Co., Ltd.) were added, and the mixture was compounded using TEX30 manufactured by JSW at 180°C. The resulting compound was freeze-pulverized and passed through a wire mesh (opening size: 160 µm) to give a powdery resin particle having an average particle diameter of 120 µm and a particle size of 0.5 to 160 µm. The resin particle was uniformly spread on an electronic substrate (200 mm x 200 mm) made of a glass epoxy resin using a wire mesh (opening size : 200 µm), and then heated under an atmosphere of a temperature of 170°C to give a substrate coated with the transparent resin.

### Example 15

To 100 parts of a copolyamide (VESTAMELT X1051), 0.3 parts of a light stabilizer HALS (NYLOSTAB S-EED manufactured by Clariant Ltd.), 0.25 parts of an ultraviolet ray absorbing agent (HOSTAVIN B-CAP manufactured by Clariant Ltd.), and 0.5 parts of a heat stabilizer (Sumilizer GA80 manufactured by Sumitomo Chemical Co. , Ltd.) were added, and mixture was compounded using TEX30 manufactured by JSW at 180°C. The resulting compound was freeze-pulverized and passed through a wire mesh (opening size: 160 µm) to give a powdery resin particle having an average particle diameter of 12 0 µm and a particle size of 0.5 to 160 µm. The resin particle was uniformly spread on an electronic substrate (200 mm x 200 mm) made of a glass epoxy resin using a wire mesh (opening size: 200 µm), and then heated under an atmosphere of a temperature of 170°C to give a substrate coated with the transparent resin.

### Example 16

To 100 parts of a copolyamide (VESTAMELT X1038 manufactured by Evonik, containing a C₁₀₋₁₄alkylene group, melting point: 125°C (DSC), melt flow rate: 15 g/10 minutes (a temperature of 160°C and a load of 2.16kg)), 0.3 parts of a light stabilizer HALS (NYLOSTAB S-EED manufactured by Clariant Ltd.,) and 0.5 parts of a heat stabilizer (Sumilizer GA80 manufactured by Sumitomo Chemical Co., Ltd.,) were added, and the mixture was compounded using TEX30 manufactured by JSW at 180°C. The resulting compound was freeze-pulverized and passed through a wire mesh (opening size: 160 µm) to give a powdery resin particle having an average particle diameter of 120 µm and a particle size of 0.5 to 160 µm. The resin particle was uniformly spread on an electronic substrate (200 mm x 200 mm) made of a glass epoxy resin using a wire mesh (opening size: 200 µm), and then heated under an atmosphere of a temperature of 170°C to give a substrate coated with the transparent resin.

### Example 17

To 100 parts of a copolyamide (VESTAMELT X1038), 0.25 parts of a light stabilizer HALS (NYLOSTAB S-EED manufactured by Clariant Ltd.) was added, and the mixture was compounded using TEX30 manufactured by JSW at 180°C. The resulting compound was freeze-pulverized and passed through a wire mesh (opening size: 160 µm) to give a powdery resin particle having an average particle diameter of 120 µm and a particle size of 0.5 to 160 µm. The resin particle was uniformly spread on an electronic substrate (200 mm x 200 mm) made of a glass epoxy resin using a wire mesh (opening size : 200 µm), and then heated under an atmosphere of a temperature of 170°C to give a substrate coated with the transparent resin.

### Example 18

To 100 parts of a copolyamide (VESTAMELT X1038), 0.25 parts of a light stabilizer HALS (NYLOSTAB S-EED manufactured by Clariant Ltd.), 0.25 parts of an ultraviolet ray absorbing agent (HOSTAVIN PR25 manufactured by Clariant Ltd.), and 0.5 parts of a heat stabilizer (Sumilizer GA80 manufactured by Sumitomo Chemical Co., Ltd.) were added, and the mixture was compounded using TEX30 manufactured by JSW at 180°C. The resulting compound was freeze-pulverized and passed through a wire mesh (opening size: 160 µm) to give a powdery resin particle having an average particle diameter of 120 µm and a particle size of 0.5 to 160 µm. The resin particle was uniformly spread on an electronic substrate (200 mm x 200 mm) made of a glass epoxy resin using a wire mesh (opening size : 200 µm), and then heated under an atmosphere of a temperature of 170°C to give a substrate coated with the transparent resin.

### Example 19

To 100 parts of a copolyamide (VESTAMID N1901 manufactured by Evonik, containing a C₁₀₋₁₄alkylene group, melting point: 155°C (DSC), melt flow rate: 5 g/10 minutes (a temperature of 190°C and load of 2.16 kg)), 0.25 parts of a light stabilizer HALS (Tinuvin 622LD manufactured by BASF), 0.25 parts of an ultraviolet ray absorbing agent (HOSTAVIN PR25 manufactured by Clariant Ltd.), and 0.5 parts of a heat stabilizer (Sumilizer GA80 manufactured by Sumitomo Chemical Co. , Ltd.) were added, and the mixture was compounded using TEX30 manufactured by JSW at 200°C. The resulting compound was freeze-pulverized and passed through a wire mesh (opening size: 160 µm) to give a powdery resin particle having an average particle diameter of 120 µm and a particle size of 0.5 to 160 µm. The resin particle was uniformly spread on an electronic substrate (200 mm x 200 mm) made of a glass epoxy resin using a wire mesh (opening size : 200 µm), and then heated under an atmosphere of a temperature of 200°C to give a substrate coated with the transparent resin.

### Example 20

To 100 parts of a copolyamide (VESTAMID N1901), 0.25 parts of a light stabilizer HALS (Chimassorb 119 manufactured by BASF), 0.25 parts of an ultraviolet ray absorbing agent (Tinuvin 312 manufactured by BASF), and 0.5 parts of a heat stabilizer (Sumilizer GA80 manufactured by Sumitomo Chemical Co. , Ltd.) were added, and the mixture was compounded using TEX30 manufactured by JSW at 200°C. The resulting compound was freeze-pulverized and passed through a wire mesh (opening size: 160 µm) to give a powdery resin particle having an average particle diameter of 120 µm and a particle size of 0.5 to 160 µm. The resin particle was uniformly spread on an electronic substrate (200 mm x 200 mm) made of a glass epoxy resin using a wire mesh (opening size: 200 µm), and then heated under an atmosphere of a temperature of 200°C to give a substrate coated with the transparent resin.

### Example 21

To 100 parts of a copolyamide (VESTAMID N1901), 0.25 parts of a light stabilizer HALS (Chimassorb 944 manufactured by BASF), 0.25 parts of an ultraviolet ray absorbing agent (Tinuvin 312 manufactured by BASF), and 0.5 parts of a heat stabilizer (Sumilizer GA80 manufactured by Sumitomo Chemical Co. , Ltd.) were added, and the mixture was compounded using TEX30 manufactured by JSW at 200°C. The resulting compound was freeze-pulverized and passed through a wire mesh (opening size: 160 µm) to give a powdery resin particle having an average particle diameter of 120 µm and a particle size of 0.5 to 160 µm. The resin particle was uniformly spread on an electronic substrate (200 mm x 200 mm) made of a glass epoxy resin using a wire mesh (opening size: 200 µm), and then heated under an atmosphere of a temperature of 200°C to give a substrate coated with the transparent resin.

### Example 22

The compound obtained in Example 12 was freeze-pulverized and passed through a wire mesh (opening size: 60 µm) to give a powdery resin particle having an average particle diameter of 45 µm and a particle size of 0.5 to 60 µm. The resin particle was uniformly spread on an electronic substrate (200 mm x 200 mm) made of a glass epoxy resin using a wire mesh (opening size: 200 µm), and then heated under an atmosphere of a temperature of 170°C to give a substrate coated with the transparent resin.

### Example 23

The compound obtained in Example 12 was freeze-pulverized and passed through a wire mesh (opening size: 80 µm) to give a powdery resin particle having an average particle diameter of 50 µm and a particle size of 0.5 to 80 µm. The resin particle was uniformly spread on an electronic substrate (200 mm x 200 mm) made of a glass epoxy resin using a wire mesh (opening size: 200 µm), and then heated under an atmosphere of a temperature of 170°C to give a substrate coated with the transparent resin.

### Example 24

The compound obtained in Example 12 was freeze-pulverized and passed through a wire mesh (opening size: 120 µm) to give a powdery resin particle having an average particle diameter of 80 µm and a particle size of 0.5 to 120 µm. The resin particle was uniformly spread on an electronic substrate (200 mm x 200 mm) made of a glass epoxy resin using a wire mesh (opening size: 200 µm), and then heated under an atmosphere of a temperature of 170°C to give a substrate coated with the transparent resin.

### Example 25

The compound obtained in Example 12 was freeze-pulverized and passed through a wire mesh (opening size: 300 µm) to give a powdery resin particle having an average particle diameter of 185 µm and a particle size of 0.5 to 300 µm. The resin particle was uniformly spread on an electronic substrate (200 mm x 200 mm) made of a glass epoxy resin using a wire mesh (opening size: 500 µm), and then heated under an atmosphere of a temperature of 170°C to give a substrate coated with the transparent resin.

### Example 26

The compound obtained in Example 12 was freeze-pulverized and passed through a wire mesh (opening size: 500 µm) to give a powdery resin particle having an average particle diameter of 280 µm and a particle size of 0.5 to 500 µm. The resin particle was uniformly spread on an electronic substrate (200 mm x 200 mm) made of a glass epoxy resin using a wire mesh (opening size: 710 µm), and then heated under an atmosphere of a temperature of 170°C to give a substrate coated with the transparent resin.

### Example 27

The compound obtained in Example 12 was freeze-pulverized and passed through a wire mesh (opening size: 1000 µm) to give a powdery resin particle having an average particle diameter of 310 µm and a particle size of 0.5 to 1000 µm. The resin particle was uniformly spread on an electronic substrate (200 mm x 200 mm) made of a glass epoxy resin using a wire mesh (opening size: 710 µm), and then heated under an atmosphere of a temperature of 170°C to give a substrate coated with the transparent resin.

### Example 28

The compound obtained in Example 12 was freeze-pulverized and passed through two wire meshes (each opening size: 80 µm, 160 µm) to give a powdery resin particle having an average particle diameter of 150 µm and a particle size of 80 to 160 µm. The resin particle was uniformly spread on an electronic substrate (200 mm x 200 mm) made of a glass epoxy resin using a wire mesh (opening size: 300 µm), and then heated under an atmosphere of a temperature of 170°C to give a substrate coated with the transparent resin.

### Example 29

The compound obtained in Example 12 was freeze-pulverized and passed through two wire meshes (each opening size: 80 µm, 200 µm) to give a powdery resin particle having an average particle diameter of 170 µm and a particle size of 80 to 200 µm. The resin particle was uniformly spread on an electronic substrate (200 mm x 200 mm) made of a glass epoxy resin using a wire mesh (opening size: 300 µm), and then heatedunder an atmosphere of a temperature of 170°C to give a substrate coated with the transparent resin.

### Example 30

The compound obtained in Example 12 was freeze-pulverized and passed through two wire meshes (each openingsize: 80 µm, 500 µm) to give a powdery resin particle having an average particle diameter of 345 µm and a particle size of 80 to 500 µm. The resin particle was uniformly spread on an electronic substrate (200 mm x 200 mm) made of a glass epoxy resin using a wire mesh (opening size: 710 µm), and then heatedunder an atmosphere of a temperature of 170°C to give a substrate coated with the transparent resin.

### Example 31

The compound obtained in Example 12 was freeze-pulverized and passed through two wire meshes (each opening size: 500 µm, 1000 µm) to give a first powdery resin particle having an average particle diameter of 620 µm and a particle size of 500 to 1000 µm. The compound obtained in Example 1 was freeze-pulverized and passed through a wire mesh (opening size: 200 µm) to give a second powdery resin particle having an average particle diameter of 165 µm and a particle size of 0.5 to 200 µm. The first resin particle (100 parts by weight) and the second resin particle (5 parts by weight) were mixed, and the mixture was uniformly spread on an electronic substrate (200 mm x 200 mm) made of a glass epoxy resin using a wire mesh (openingsize: 710 µm), and then heated under an atmosphere of a temperature of 170°C to give a substrate coated with the transparent resin.

Each sealant used in Examples was evaluated for sealing performance, peeling property, water resistance, and weatherability. The results are shown in the following Tables. In the table, each numerical value in the peel test and the water resistance test indicates the number of peeled squares out of 100 squares in the cross-cut peel test. In the tables, the value in the weather resistance test represents the number of substrates that LED was of f.

[Table 3]

**Table 3**

| | | | Examples | | | | | | | | | |
|---|---|---|---|---|---|---|---|---|---|---|---|---|
| | | | 12 | 13 | 14 | 15 | 16 | 17 | 18 | 19 | 20 | 21 |
| Copolyamide | VESTAMELT X1051 | manufactured by Evonik | 100 | 100 | 100 | 100 | - | - | - | - | - | - |
| | VESTAMELT X1038 | manufactured by Evonik | - | - | - | - | 100 | 100 | 100 | - | - | - |
| | VESTAMID N1901 | manufactured by Evonik | - | - | - | - | - | - | - | 100 | 100 | 100 |
| Homopolyamide | DAIAMID A1709 | manufactured by Daicel-Evonik Ltd. | - | - | - | - | - | - | - | - | - | - |
| Heat stabilizer | Sumilizer GA80 | manufactured by Sumitomo Chemical Co. , Ltd. | 0.5 | - | 0.5 | 0.5 | 0.5 | - | 0.5 | 0.5 | 0.5 | 0.5 |
| UV ray absorbing agent | Tinuvin 234 | manufactured by BASF | 0.25 | - | - | - | - | - | - | - | - | - |
| | Tinuvin 312 | manufactured by BASF | - | - | - | - | - | - | - | - | 0.25 | 0.25 |
| | HOSTAVIN C-CAP | manufactured by Clariant Ltd. | - | 0.25 | - | 0.25 | - | - | - | - | - | - |
| | HOSTAVIN PR25 | manufactured by Clariant Ltd. | - | - | 0.25 | - | - | - | 0.25 | 0.25 | - | - |
| HALS | Tinuvin 622LD | manufactured by BASF | 0.25 | - | - | - | - | - | - | 0.25 | - | - |
| | NYLOSTAB S-EED | manufactured by Clariant Ltd. | - | 0.5 | 0.3 | 0.3 | 0.3 | 0.25 | 0.25 | - | - | - |
| | Chimassorb 119 | manufactured by BASF | - | - | - | - | - | - | - | - | 0.25 | - |
| | Chimassorb 944 | manufactured by BASF | - | - | - | - | - | - | - | - | - | 0.25 |
| Sealing performance | | Flat | 5 | 5 | 5 | 5 | 5 | 5 | 5 | 5 | 5 | 5 |
| | | Protruded portion 2 mm | 5 | 5 | 5 | 5 | 5 | 5 | 5 | 5 | 5 | 5 |
| | | Protruded portion 20 mm | 5 | 5 | 5 | 5 | 5 | 5 | 5 | 5 | 5 | 5 |
| Peel test | | | 0 | 0 | 0 | 0 | 0 | 0 | 0 | 0 | 0 | 0 |
| Water resistance test | | | 0 | 0 | 0 | 0 | 0 | 0 | 0 | 0 | 0 | 0 |
| Weather resistance test | | | 0 | 0 | 0 | 0 | 0 | 0 | 0 | 0 | 0 | 0 |

[Table 4]

**Table 4**

| | | | Examples | | | | | | | | | |
|---|---|---|---|---|---|---|---|---|---|---|---|---|
| | | | 22 | 23 | 24 | 25 | 26 | 27 | 28 | 29 | 30 | 31 |
| Copolyamide | VESTAMELT X1051 | manufactured by Evonik | 100 | 100 | 100 | 100 | 100 | 100 | 100 | 100 | 100 | 100 |
| Heat stabilizer | Sumilizer GA80 | manufactured by Sumitomo Chemical Co., Ltd. | 0.5 | 0.5 | 0.5 | 0.5 | 0.5 | 0.5 | 0.5 | 0.5 | 0.5 | 0.5 |
| UV ray absorbing agent | Tinuvin 234 | manufactured by BASF | 0.25 | 0.25 | 0.25 | 0.25 | 0.25 | 0.25 | 0.25 | 0.25 | 0.25 | 0.25 |
| HALS | Tinuvin 622LD | manufactured by BASF | 0.25 | 0.25 | 0.25 | 0.25 | 0.25 | 0.25 | 0.25 | 0.25 | 0.25 | 0.25 |
| Particle size distribution (µm) | | | 0.5 to 60 | 0.5 to 80 | 0.5 to 120 | 0.5 to 300 | 0.5 to 500 | 0.5 to 1000 | 80 to 160 | 80 to 200 | 80 to 500 | 0.5 to 200 500 to 1000 |
| Average particle diameter (µm) | | | 45 | 50 | 80 | 185 | 280 | 310 | 150 | 170 | 345 | 165 620 |
| Angle of repose (°) | | | 49 | 47 | 44 | 39 | 40 | 37 | 37 | 38 | 37 | 40 |
| Angle of rupture (°) | | | - | 22 | - | - | 22 | 23 | - | - | 22 | 22 |
| Melting time (sec.) | | | 30 | 32 | 39 | 55 | 66 | 74 | 73 | 74 | 80 | 84 |
| Sealing performance | Flat | | 5 | 5 | 5 | 5 | 5 | 5 | 5 | 5 | 5 | 5 |
| | Protruded portion 2 mm | | 5 | 5 | 5 | 5 | 5 | 5 | 5 | 5 | 5 | 5 |
| | Protruded portion 20 mm | | 5 | 5 | 5 | 5 | 5 | 5 | 5 | 5 | 5 | 5 |
| Peel test | | | 0 | 0 | 0 | 0 | 0 | 0 | 0 | 0 | 0 | 0 |
| Water resistance test | | | 0 | 0 | 0 | 0 | 0 | 0 | 0 | 0 | 0 | 0 |
| Weather resistance test | | | 0 | 0 | 0 | 0 | 0 | 0 | 0 | 0 | 0 | 0 |

As apparent from the Tables, Examples show high sealing performance in both of the flat portion and the protrudedportion as well as have excellent adhesion, water resistance, and weatherability.

### INDUSTRIAL APPLICABILITY

The present invention is useful for molding or sealing of an electronic device or electronic part (e.g. , a semiconductor element, an EL device, and a solar cell) or a printed wiring board equipped with a variety of electronic parts or electronic devices at a low temperature.

## Claims

1. A powdery sealant for sealing a device, the sealant comprising a copolyamide-series resin particle having a particle diameter of not more than 1 mm, and the copolyamide-series resin particle containing at least (A) a copolyamide-series resin particle having an average particle diameter of 20 to 400 µm.

2. A powdery sealant according to claim 1, wherein the copolyamide-series resin particle (A) has an average particle diameter of 40 to 350 µm.

3. A powdery sealant according to claim 1 or 2, wherein the copolyamide-series resin particle further contains (B) a copolyamide-series resin particle having an average particle diameter of 1.2 to 20 times as large as the average particle diameter of the copolyamide-series resin particle (A).

4. A powdery sealant according to claim 3 , wherein the copolyamide-series resin particle (B) has an average particle diameter of 450 to 800 µm.

5. A powdery sealant according to claim 3 or 4, wherein the amount of the copolyamide-series resin particle (A) is 1 to 10 parts by weight relative to 100 parts by weight of the copolyamide-series resin particle (B).

6. A powdery sealant according to any one of claims 1 to 5, wherein the whole of the copolyamide-series resin particle has an angle of repose of 35 to 55°.

7. A powdery sealant according to any one of claims 1 to 6, wherein the copolyamide-series resin has a melting point or softening point of 75 to 160°C.

8. A powdery sealant according to any one of claims 1 to 7, wherein the copolyamide-series resin is a crystalline resin.

9. A powdery sealant according to any one of claims 1 to 8, wherein the copolyamide-series resin is a crystalline resin and has a melting point of 90 to 160°C.

10. Apowdery sealant according to anyone of claims 1 to 9, wherein the copolyamide-series resin comprises a multiple copolymer.

11. A powdery sealant according to any one of claims 1 to 10, wherein the copolyamide-series resin comprises at least one selected from the group consisting of a binary copolymer to a quaternary copolymer.

12. A powdery sealant according to anyone of claims 1 to 11, wherein the copolyamide-series resin contains a unit derived from a long-chain component having a C₈₋₁₆alkylene group.

13. A powdery sealant according to anyone of claims 1 to 12, wherein the copolyamide-series resin contains a unit derived from at least one component selected from the group consisting of a C₉₋₁₇lactam and an aminoC₉₋₁₇alkanecarboxylic acid.

14. Apowdery sealant according to any one of claims 1 to 13, wherein the copolyamide-series resin contains a unit derived from an amide-forming component for forming a polyamide selected from the group consisting of a polyamide 11, a polyamide 12, a polyamide 610, a polyamide 612, and a polyamide 1010.

15. Apowdery sealant according to any one of claims 1 to 14, wherein the copolyamide-series resin comprises at least one member selected from the group consisting of a copolyamide 6/11, a copolyamide 6/12, a copolyamide 66/11, a copolyamide 66/12, a copolyamide 610/11, a copolyamide 612/11, a copolyamide 610/12, a copolyamide 612/12, a copolyamide 1010/12, a copolyamide 6/11/610, a copolyamide 6/11/612, a copolyamide 6/12/610, and a copolyamide 6/12/612.

16. Apowdery sealant according to any one of claims 1 to 15, wherein the copolyamide-series resin contains a unit derived from at least one component selected from the group consisting of laurolactam, aminoundecanoic acid, and aminododecanoic acid.

17. A powdery sealant according to any one of claims 1 to 16, which further comprises a hindered amine-series light stabilizer.

18. Apowdery sealant according to claim 17 , wherein the amount of the hindered amine-series light stabilizer is 0.1 to 2 parts by weight relative to 100 parts by weight of the copolyamide-series resin.

19. A powdery sealant according to claim 17 or 18, which further comprises at least one ultraviolet ray absorbing agent selected from the group consisting of a benzylidenemalonate-series ultraviolet ray absorbing agent, an oxanilide-series ultraviolet ray absorbing agent, and a benzotriazole-series ultraviolet ray absorbing agent.

20. Apowdery sealant according to any one of claims 17 to 19, which comprises a hindered phenolic heat stabilizer.

21. A process for producing a device covered or molded with a copolyamide-series resin, the process comprising:
applying a powdery sealant recited in any one of claims 1 to 20 to at least a region of a device,
heat-melting the powdery sealant, and
cooling the powdery sealant.

22. A device of which at least a region is covered or molded with a copolyamide-series resin layer, the layer being formed by heat-melting a powdery sealant recited in any one of claims 1 to 20 on the device.
